(19) Europäisches Patentamt
European Patent Office
Office européen des brevets

(11) **EP 2 512 001 A2**

(12) **EUROPEAN PATENT APPLICATION**

(43) Date of publication:
**17.10.2012 Bulletin 2012/42**

(51) Int Cl.:
*H02J 5/00* *(2006.01)*     *H02J 7/02* *(2006.01)*

(21) Application number: **12162433.2**

(22) Date of filing: **30.03.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.04.2011 JP 2011090036**

(71) Applicant: **Sony Corporation Tokyo 108-0075 (JP)**

(72) Inventor: **Sato, Kazuhiro Tokyo 108-0075 (JP)**

(74) Representative: **Körber, Martin Hans Mitscherlich & Partner Sonnenstraße 33 80331 München (DE)**

(54) **Power control apparatus, power control method, and program in contactless power transmission**

(57)     There is provided a power control apparatus including a calculating unit that calculates contactless transmission efficiency of power from each of a plurality of devices when the power is received from one device of the plurality of devices and a control unit that controls contactless power transmission from a device in which the transmission efficiency is high.

FIG.1

Printed by Jouve, 75001 PARIS (FR)

**Description**

BACKGROUND

The present disclosure relates to a power control apparatus, a power control method, and a program, and more particularly, to a power control apparatus, a power control method, and a program that enable efficient charging.

Conventionally, a contactless power transmission technique of contactlessly charging an embedded battery has been known. For example, a device such as an electric toothbrush in which charging is performed by transmitting power from a power transmitter connected to a wall socket to a battery embedded in the electric toothbrush exists. In the device such as the electric toothbrush, there is a power transmitter for exclusive use of the electric toothbrush, the electric toothbrush is set on the power transmitter, and charging is performed.

In addition, a technique of transmitting power from one of portable devices having embedded batteries, receiving the power by the other, and performing charging is suggested in Japanese Patent No. 4171758 and Japanese Patent Application Laid-Open Nos. 2005-151609, 2005-143181, and 2010-183814.

SUMMARY

In the technology disclosed in Japanese Patent No. 4171758 and Japanese Patent Application Laid-Open Nos. 2005-151609, 2005-143181, and 2010-183814 and the contactless power transmission technology executed by the electric toothbrush, one-to-one power transmission and charging are assumed. For example, because the electric toothbrush is charged by a combination with the power transmitter for exclusive use, portable terminals other than the electric toothbrush may not be charged.

In the contactless power transmission, when a distance between a power transmitting device and a power receiving device is short, efficient charging is enabled. However, because a distance between portable terminals is not constant due to a characteristic of the portable devices, it is difficult to maintain an optimal distance relation between the portable terminals at all times. Even if there are a plurality of power transmitting devices, it is not yet possible to select a device enabling efficient charging from the devices and perform charging. For this reason, there has been a need to perform efficient charging in the contactless power transmission.

The present disclosure has been made in view of the above circumstances and enables contactless power transmission with a device with high power transmitting/receiving efficiency when charging is necessary.

Various aspects and features of the invention are defined in the appended claims. According to an embodiment of the present disclosure, there is provided a power control apparatus which includes a calculating unit that calculates transmission efficiency of power from each of a plurality of devices when the power is received from one device of the plurality of devices and a control unit that controls power transmission from a device in which the transmission efficiency is high.

The power control apparatus may further include an acquiring unit that acquires information regarding a value of the power transmitted from each of the plurality of devices and a remaining amount of a battery and a measuring unit that receives the power from each of the plurality of devices and measures a value of the received power. The calculating unit may divide the value of the received power measured by the measuring unit by the value of the transmitted power included in the information to calculate the transmission efficiency and the control unit may control the power transmission from a device in which a value obtained by multiplying the remaining amount of the battery and the transmission efficiency is large.

A time after the power transmission is controlled by the control unit may be clocked, the power transmission may be stopped when a set time passes, and the transmission efficiency may be calculated by the calculating unit again among the plurality of devices.

The clocking time may be set long when the transmission efficiency is stable and the clocking time may be set short when the transmission efficiency is unstable.

A plurality of coils may be provided, a coil that is located at a position close to the device performing the power transmission may be used, and the power transmission may be performed.

The power transmission may be performed through a device performing power transmission and power reception.

In the device performing the power transmission and the power reception, the power transmission and the power reception may be performed by time sharing.

A resonance frequency may be set to a frequency used by a counterpart-side device performing the power transmission and the power transmission may be performed.

A communication may be performed through a server connected to a network.

According to another embodiment of the present disclosure, there is provided a power control method which includes calculating transmission efficiency of power from each of a plurality of devices when the power is received from one device of the plurality of devices and controlling power transmission from a device in which the transmission efficiency is high.

According to another embodiment of the present disclosure, there is provided a program for causing a computer to execute a power control process. The power control process includes calculating transmission efficiency of power from each of a plurality of devices when the power is received from one device of the plurality of devices and controlling power transmission from a device in which the transmission efficiency is high.

In the power control apparatus, the power control method, and the program according to the embodiments of the present disclosure described above, when the power is received from one device of the plurality of devices, the transmission efficiency of the power from each of the plurality of devices is calculated and the power transmission from the device in which the transmission efficiency is high is controlled.

According to the embodiments of the present disclosure described above, contactless power transmission with a device with high power transmitting/receiving efficiency can be performed when charging is necessary.

BRIEF DESCRIPTION OF THE DRAWINGS

Embodiments of the invention are now described with reference to the enclosed drawings, throughout which like parts are referred to be like references, and in which,

FIG 1 is a diagram illustrating a distance between terminals;
FIG 2 is a flowchart illustrating a process regarding power reception;
FIG 3 is a diagram illustrating a configuration example of three devices;
FIG 4 is a flowchart illustrating a process regarding power reception;
FIG 5 is a flowchart illustrating a process regarding power reception;
FIG 6 is a flowchart illustrating a process regarding power transmission;
FIG 7 is a diagram illustrating another configuration example of three devices;
FIG 8 is a flowchart illustrating a process regarding power reception;
FIG 9 is a flowchart illustrating a process regarding power reception;
FIG. 10 is a diagram illustrating a configuration example of a device having a function of a repeater;
FIG 11 is a diagram illustrating a configuration example of a device having a function of a repeater;
FIG 12 is a diagram illustrating positions of coils;
FIG 13 is a diagram illustrating positions of coils;
FIG 14 is a diagram illustrating another configuration example of three devices; and
FIG 15 is a diagram illustrating a recording medium.

DETAILED DESCRIPTION OF THE EMBODIMENT(S)

Hereinafter, preferred embodiments of the present disclosure will be described in detail with reference to the appended drawings. Note that, in this specification and the appended drawings, structural elements that have substantially the same function and structure are denoted with the same reference numerals, and repeated explanation of these structural elements is omitted.

Hereinafter, embodiments of the present disclosure will be described with reference to the drawings.

[First Embodiment]

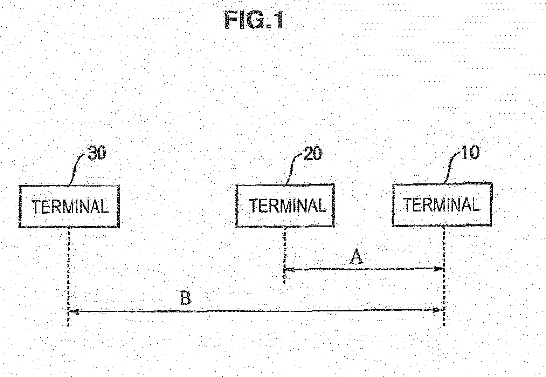

According to the present disclosure, contactless power transmission with a device having high power transmission and power reception efficiency is performed when charging is necessary. For example, as illustrated in FIG 1, the contactless power transmission with the device having the high power transmission and power reception efficiency will be described using an example of the case in which there are three terminals.

Terminals 10, 20, and 30 are portable terminals and can be carried by a user. Therefore, the distance between the two terminals among the terminals 10, 20, and 30 may change. A state illustrated in FIG 1 is a state in which the terminals 10 and 20 are apart from each other by the distance A and the terminals 10 and 30 are apart from each other by a distance B. The distance A is shorter than the distance B. That is, the state illustrated in FIG 1 is a state in which the terminal 10 is closer to the terminal 20 than the terminal 30.

In this state, the case in which a remaining amount of a battery embedded in the terminal 10 becomes a predetermined value or less and charging becomes necessary is considered. The terminals 10 and 20 and the terminals 10 and 30 are configured to perform contactless power transmission, respectively, so that power is transmitted from one terminal and the power is received by the other terminal and charging can be performed. When a capacity of a battery of the terminal 20 is compared with a capacity of a battery of the terminal 30 and it is determined that the capacity of the battery of the terminal 30 is larger than the capacity of the battery of the terminal 20, the terminal 10 receives power transmitted from the terminal 30 having the large capacity and performs charging.

When an electromagnetic induction method is adopted as a method of contactless power transmission, transmission efficiency is inversely proportional to the square of the distance. For example, in the case in which the distance between the terminals is 1 cm and the case in which the distance between the terminals is 10 cm, the difference of the distances is 10 times, but the difference of transmission efficiencies may be 100 times, which is the square of the distance. That is, if the distance is short, charging is performed with high transmission efficiency. However, if the distance is long, the charging may be performed with low transmission efficiency. If this situation is considered, when the terminal 10 performs the charging, receiving power transmitted from the terminal 20 is more preferable than receiving power transmitted from the terminal 30 having the large capacity of the battery, because the charging can be performed efficiently.

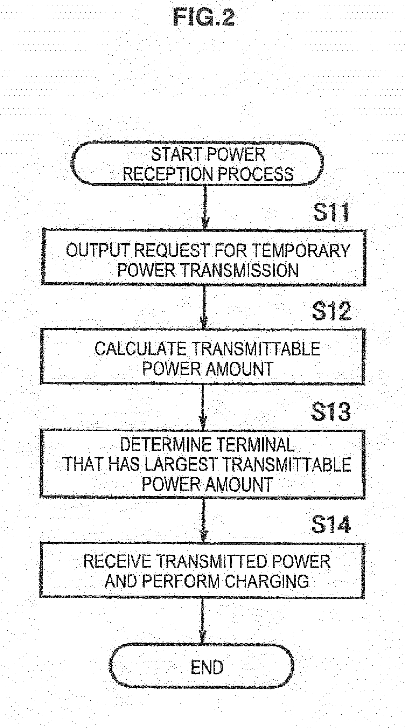

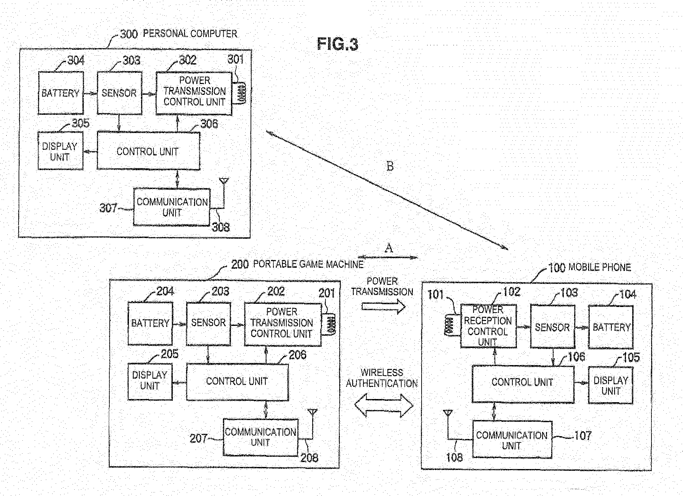

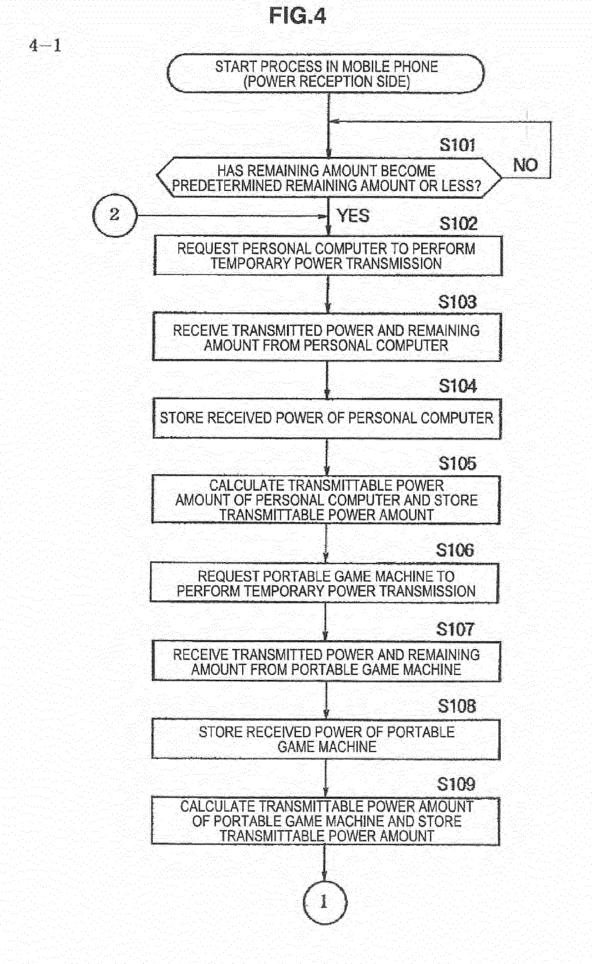

When the charging is performed in a contactless type, if conditions such as the capacity (remaining amount) of the battery of the terminal transmitting the power and the distance are not considered, the power transmission and the power reception may not be performed efficiently and the charging may not be performed efficiently. Therefore, a process to be described below is executed when the charging is necessary. First, the outline will be described with reference to a flowchart of FIG 2. In addition, a specific example of the terminal will be described with reference to FIG 3 and a detailed operation for each terminal will be described with reference to FIG 4 and the following drawings.

FIG 2 is a flowchart illustrating a process that is executed by a terminal needing to perform charging, in this case, the terminal 10. When the terminal 10 monitors the remaining amount of its battery and determines that the remaining amount has become a predetermined value or less, the terminal 10 starts the process of the flowchart illustrated in FIG 2. In step S11, the terminal 10 outputs a request for temporary power transmission. The temporary power transmission is performed in a step before transmitted power is received and charging is performed in a process of a subsequent stage and is performed for only a short time to acquire information to determine the terminal from which power is transmitted at the time of receiving power.

The request for temporary power transmission in step S11 is performed with respect to the terminal registered previously in the terminal 10. For example, when the terminals 20 and 30 are registered in the terminal 10, the request for temporary power transmission is output to each of the terminals 20 and 30. According to the request, the terminal 20 or 30 performs the temporary power transmission. If the temporary power transmission is performed, the terminal 10 acquires information to calculate transmission efficiency. The terminal 10 calculates a transmittable power amount from the acquired information, in step S12. The transmittable power amount is calculated by the following Equation 1.

$$\text{Transmittable power amount} = \text{remaining amount} \times \text{transmission efficiency} \cdots (1)$$

The transmittable power amount becomes a value that is obtained by multiplying the remaining amount of the battery of the terminal becoming a power transmission origin and transmission efficiency of the power transmitted from the terminal. The transmission efficiency will be described in detail below. Information on the value of the power that is transmitted from the terminal is provided by the terminal and the transmission efficiency is calculated from the provided information and the actually received power. If the terminal 10 calculates the transmittable power amount based on the information or the transmitted power from each terminal (terminal 20 or 30) for each terminal, the process proceeds to step S13.

In step S13, the terminal that has the largest transmittable power amount is determined. Next, in step S14, the power is received from the determined terminal and the charging starts. By receiving the transmitted power until the charging is completed, the charging is continuously performed.

The transmittable power amount is calculated from the remaining amount and the transmission efficiency, as seen in Equation 1. Therefore, if the transmission efficiency is low even though the remaining amount is large, the value of the transmittable power amount decreases and the corresponding terminal is not selected as the terminal of the power transmission origin. For example, even though the remaining amount of the battery of the terminal 30 is larger than the remaining amount of the battery of the terminal 20, the calculated transmittable power amount of the terminal 30 becomes smaller than the transmittable power amount of the terminal 20, because the distance from the terminal 10 to the terminal 30 is longer than the distance from the terminal 10 to the terminal 20. As a result, the terminal 30 is not selected as the power transmission origin and the terminal 20 is selected as the power transmission origin.

For example, when the remaining amount of the battery of the terminal 20 is larger than the remaining amount of the battery of the terminal 30, the calculated transmittable power amount of the terminal 20 becomes larger than the calculated transmittable power amount of the terminal 30 because the distance from the terminal 10 to the terminal 20 is shorter than the distance from the terminal 10 to the terminal 30. As a result, the terminal 20 is selected as the power transmission origin.

As such, because the power transmission origin is determined in consideration of both the remaining amount of the battery and the transmission efficiency, the power transmission, the power reception, and the charging can be performed efficiently.

[Specific Structure of the First Embodiment]

Hereinafter, the terminals 10, 20, and 30 will be described in detail using specific examples. FIG. 3 is a diagram illustrating a configuration example of the case in which the terminal 10 illustrated in FIG 1 is a mobile phone, the terminal 20 is a portable game machine, and the terminal 30 is a personal computer.

A mobile phone 100 includes a coil 101, a power reception control unit 102, a sensor 103, a battery 104, a control unit 106, a display unit 105, a communication unit 107, and an antenna 108. Hereinafter, although necessary portions are illustrated and described, illustration and description of functions of the mobile phone 100 as a phone are appropriately omitted. Likewise, illustration and description of functions of the other devices are appropriately omitted.

A portable game machine 200 includes a coil 201, a power transmission control unit 202, a sensor 203, a battery 204, a control unit 206, a display unit 205, a communication unit 207, and an antenna 208. A personal computer 300 includes a coil 301, a power transmission control unit 302, a sensor 303, a battery 304, a control unit 306, a display unit 305, a communication unit 307, and an antenna 308.

Each of the batteries 104, 204, and 304 is a secondary battery such as a lithium ion battery and is a chargeable battery. Each of the communication units 107, 207, and 307 performs communication with other terminals using wireless fidelity (Wi-Fi), Zigbee, Bluetooth, near field communication (NFC), and infrared rays. In this case, the description is given using Wi-Fi.

The coil 101 of the mobile phone 100 is connected to the power reception control unit 102 and receives power transmitted from another device. The received power is supplied to the sensor 103, under the control of the power reception control unit 102. The sensor 103 measures the received power or supplies the power to the battery 104 to charge the battery 104. The battery 104 supplies the power to each unit of the mobile phone 100. The display unit 105 functions as a user interface that displays a telephone number or a calling image. The control unit 106 controls each unit of the mobile phone 100. The communication unit 107 performs a control operation to receive data from another device or transmit data to another device.

In the description below, because the mobile phone 100 receives the power transmitted from another device and performs the charging, the mobile phone 100 includes the power reception control unit 102. However, the mobile phone 100 may be configured to function as the device transmitting the power. Although not illustrated in the drawings, the mobile phone 100 may be configured to include a power transmission control unit to control the power transmission.

The coil 201 of the portable game machine 200 is connected to the power transmission control unit 202 and transmits power to another device. The power that is supplied from the battery 204 through the sensor 203 is transmitted, under the control of the power transmission control unit 202. The sensor 203 monitors the remaining amount of the battery 204. The battery 204 supplies the power to each unit of the portable game machine 200. The display unit 205 functions as a user interface to display contents of a game. The control unit 206 controls each unit of the portable game machine 200. The communication unit 207 performs a control operation to receive data from another device or transmit data to another device.

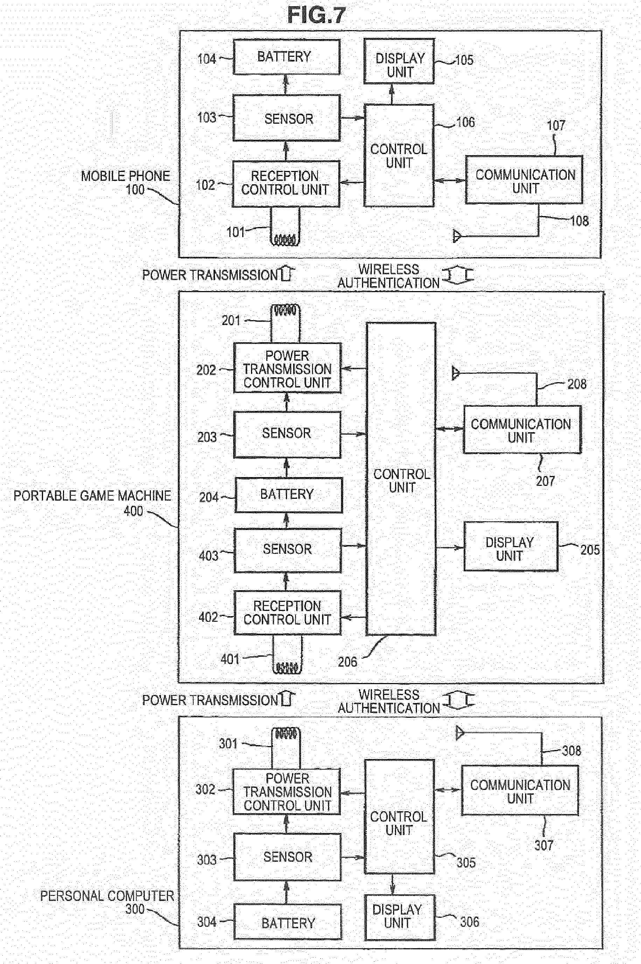

In the description below, because the portable game machine 200 receives the request from another device and performs the power transmission, the portable game machine 200 includes the power transmission control unit 202. However, the portable game machine 200 may be configured to function as the device receiving the transmitted power and performing the charging. For example, as illustrated in FIG 7, the portable game machine 200 may be configured to include a power reception control unit to control the power reception.

The coil 301 of the personal computer 300 is connected to the power transmission control unit 302 and transmits the power to another device. The power that is supplied from the battery 304 through the sensor 303 is transmitted under the control of the power transmission control unit 302. The sensor 303 monitors the remaining amount of the battery 304. The battery 304 supplies the power to each unit of the personal computer 300. The display unit 305 functions as a user interface that displays a character or an image. The control unit 306 controls each unit of the personal computer 300. The communication unit 307 performs a control operation to receive data from another device and transmit data to another device.

In the description below, similar to the portable game machine 200, because the personal computer 300 receives the request from another device and performs the power transmission, the personal computer 300 includes the power transmission control unit 302. However, the personal computer 300 may be configured to function as a device receiving the transmitted power and performing the charging. Although not illustrated in the drawings, the personal computer may be configured to include a power reception control unit to control the power reception.

[Process of the Power Reception Side]

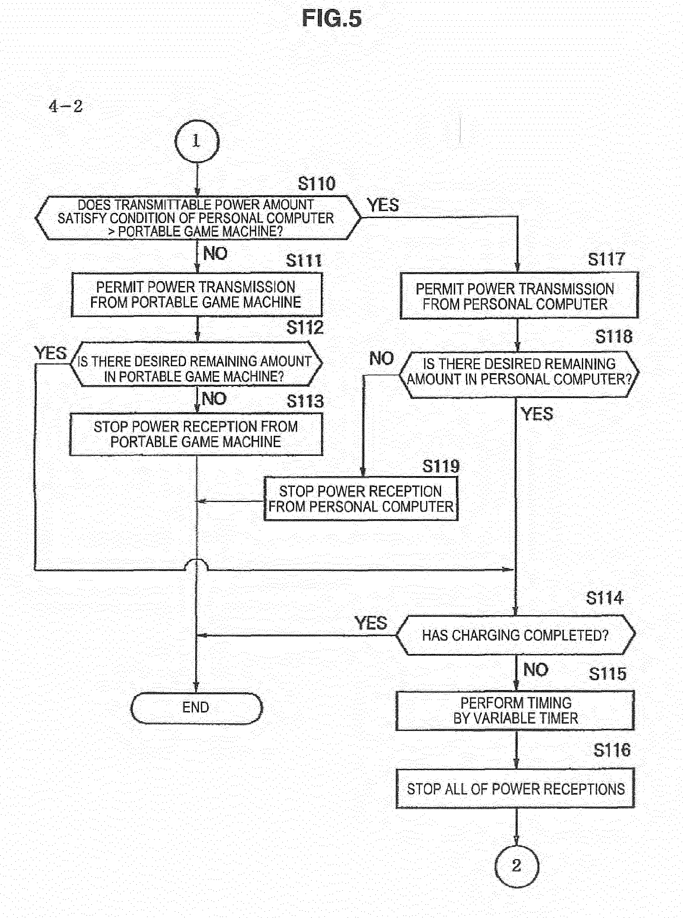

Next, a process that is executed by the mobile phone 100 when the battery of the mobile phone 100 is consumed and the charging needs to be performed in FIG 3 will be described with reference to flowcharts of FIGS. 4 and 5.

In step S101, it is determined whether the remaining amount of the battery has become the predetermined remaining amount of the battery or less. The sensor 103 monitors the remaining amount of the battery 104. The control unit 106 determines whether the remaining amount of the battery monitored by the sensor 103 has become a predetermined value or less at all times or at a predetermined interval. When the control unit 106 determines that the remaining amount of the battery monitored by the sensor 103 has become the predetermined value or less, it is determined that the remaining amount of the battery has become the predetermined remaining amount of the battery or less in step S101 and the process proceeds to step S 102.

In step S102, the request for temporary power transmission is output to the personal computer 300. In the mobile phone 100, the portable game machine 200, and the personal computer 300, MACs are registered previously such that authentication can be performed between the individual terminals. The mobile phone 100 first outputs a permission (request) for temporary power transmission to the personal computer 300 using the MACs. The request for temporary power transmission and wireless authentication are performed by the control of the communication unit 107 of the mobile phone 100.

The personal computer 300 that has received the request for temporary power transmission performs the temporary power transmission according to the request. At the time of the temporary power transmission, the predetermined power is transmitted contactlessly from the battery 304 to the mobile phone 100 under the control of the power transmission control unit 302 of the personal computer 300. Meanwhile, information such as a value of the transmitted power and the capacity (remaining amount) of the battery 304 is transmitted using wireless communication, in this case, Wi-Fi, under the control of the communication unit 307 of the personal computer 300.

In step 103, the mobile phone 100 receives the information on the value of the power (hereinafter referred to as transmission scheduled power) and the remaining amount of the battery transmitted from the personal computer 300 by the communication unit 107 and receives the power transmitted by the power reception control unit 102. In step S104, the information transmitted from the personal computer 300 and the received power are stored. The value of the received power becomes the value that is measured by the sensor 103. The sensor 103 measures the value of the power using values of a current and a voltage measured whenever some temporary loads based on a plurality of resistors are connected. The measured power is stored as the received power (hereinafter referred to as measured power). In step S105, the transmittable power amount of the personal computer 300 is calculated and stored.

The control unit 106 calculates the transmission efficiency using the transmission scheduled power and the measured power. That is, the transmission efficiency is calculated by dividing the measured power by the received power. When the information transmitted from the personal computer 300 is the information on the remaining amount of the battery, the value of the remaining amount of the battery is used. When the information transmitted from the personal computer 300 is information such as percentages regarding the capacity and the remaining amount of the battery, the capacity is multiplied by the percentage regarding the remaining amount, a value of the remaining amount is calculated and used, and the transmittable power amount is calculated. The transmittable power amount is calculated by Equation 1 as described above. Equation 1 is shown again.

$$\text{Transmittable power amount} = \text{remaining amount} \times \text{transmission efficiency} \cdots \text{equation (1)}$$

For example, when information showing that the capacity of the battery 304 is 8000 mAh and the remaining amount of the battery is 50% is received from the personal computer 300, the remaining amount of the battery is calculated as 4000 mAh. When the transmission efficiency is calculated as 5%, the transmittable power amount is calculated as 4000 mAh x 5% = 200 mAh. Because the transmittable power amount calculated in the above-described manner is compared with the transmittable power amount of another device in a process of a subsequent stage, the transmittable power amount is temporarily stored.

Next, in steps S106 to S109, the same process as the process executed with respect to the personal computer 300 is also executed with respect to the portable game machine 200. First, the request for temporary power transmission is output to the portable game machine 200. In step S107, the information regarding the transmitted power and the remaining amount is received from the portable game machine 200, the temporary power transmission is performed, and the power is received. In step S108, the information and the received power are stored. In step S109, the transmittable power amount of the portable game machine 200 is calculated.

For example, when the information showing that the capacity of the battery 204 is 2000 mAh and the remaining amount of the battery is 50% is received from the portable game machine 200, the remaining amount of the battery is calculated as 1000 mAh. When the transmission efficiency is calculated as 50%, the transmittable power amount is calculated as 1000 mAh x 50% = 500 mAh. Because the transmittable power amount calculated in the above-described manner is compared with the transmittable power amount of another device in a process of a subsequent stage, the transmittable power amount is temporarily stored.

In this way, if the mobile phone 100 calculates each of the transmittable power amount of the portable game machine 200 and the transmittable power amount of the personal computer 300 and stores each transmittable power amount, the process proceeds to step S110 (refer to FIG 5). In this case, because the two devices of the portable game machine 200 and the personal computer 300 are registered as the power transmission origins of the power in the mobile phone 100, the process is executed with respect to the two devices. However, when another device is registered, the same process is repeated with respect to the corresponding device, and the transmittable power amount in the corresponding device is calculated. The data regarding the remaining amount is transmitted from the power transmission origin. However, a value that is obtained by subtracting minimum power necessary for operating the device of the transmission side from the remaining amount may be transmitted.

In step S110, it is determined whether the transmittable power amount satisfies a condition of personal computer > portable game machine. As in the above example, when the transmittable power amount of the personal computer 300 is 200 mAh and the transmittable power amount of the portable game machine 200 is 500 mAh, the process proceeds to step S111, because it is determined that the condition of personal computer > portable game machine is not satisfied.

Referring to FIG 3 again, the portable game machine 200 is located at a position close to the mobile phone 100. However, the personal computer 300 has the large capacity of the battery (large remaining amount of the battery). In this case, because the remaining amount of the battery of the personal computer 300 is larger than the remaining amount of the battery of the portable game machine 200, it is preferable that the power be received from the personal computer 300 and the charging be performed. However, because the personal computer 300 and the mobile phone 100 are apart from each other, the transmission efficiency is low.

When the power is received from the personal computer 300 and the charging is performed, a long time is necessary until the charging is completed and the battery of the personal computer 300 may be consumed because the transmission efficiency is low. A ratio of the total power reception amount of the mobile phone 100 with respect to the total power transmission amount from the personal computer 300 becomes small and the charging is performed inefficiently. However, in this embodiment, because the transmitted power is received in consideration of the remaining amount and the transmission efficiency, the power is supplied from the portable game machine 200, not the personal computer 300 having the large remaining amount.

Because the power is supplied from the portable game machine 200 and the distance of the portable game machine 200 and the mobile phone 100 is short, the power transmission is performed efficiently. As a result, the charging can be performed efficiently. Therefore, the charging time can be shortened. If the charging time is shortened, the power transmission time is shortened and the battery 204 of the portable game machine 200 can be prevented from being consumed.

In step S110, when it is determined that the transmittable power amount does not satisfy the condition of personal computer > portable game machine, the process proceeds to step S111. In step S111, the power transmission from the portable game machine 200 is permitted. The wireless communication with the portable game machine 200 is performed by the communication unit 107 of the mobile phone 100 and the permission for power transmission (instruction of power transmission start) is output to the portable game machine 200.

If the portable game machine 200 receives the instruction of the power transmission, the portable game machine 200 starts the power transmission. The power that is transmitted from the portable game machine 200 is received by the coil 101 of the mobile phone 100, supplied to the power reception control unit 102, and supplied to the battery 104 through the sensor 103. As a result, the battery 104 is charged.

When the charging is performed, a message or an image enabling a user to recognize that the charging is performed is displayed on the display unit 105 of the mobile phone 100. On the display unit 205 of the portable game machine 200 that becomes the power transmission origin, a message or an image enabling a user to recognize that the charging is performed is displayed. However, no information may be displayed on the display unit. Even if information is displayed, the information may be displayed for only a predetermined time.

In step S112, it is determined whether there is the desired remaining amount in the portable game machine 200. The portable game machine 200 notifies the mobile phone 100 of the remaining amount of the battery 204 at a predetermined interval and the mobile phone 100 determines whether there is the desired remaining amount in the portable game machine 200 from the notification. The notification can be performed in the same manner as that when the information regarding the remaining amount of the battery 204 is transmitted at the time of the temporary power transmission.

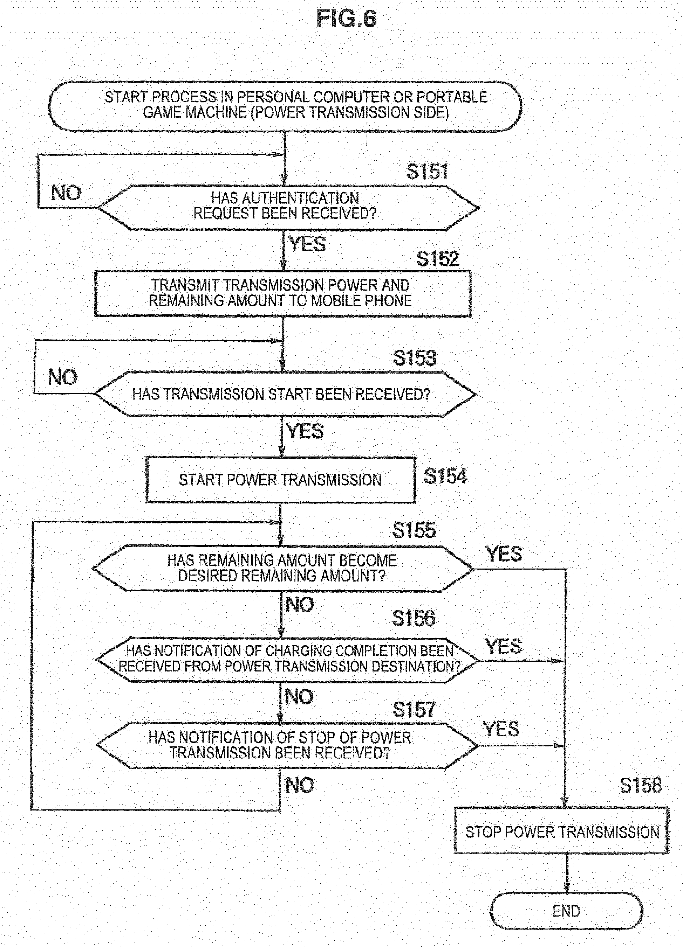

As will be described below with reference to FIG 6, the portable game machine 200 transmits the power. In order to secure the power necessary when the portable game machine 200 operates, the portable game machine 200 monitors the battery 204 and determines whether the remaining amount of the battery has become the predetermined remaining amount or less. When it is determined that the capacity of the battery has become the predetermined value or less by the power transmission, the portable game machine 200 outputs the notification and stops the power transmission. In the case of the above structure, the control unit 106 of the mobile phone 100 determines whether the notification of the stop of the power transmission is received from the portable game machine 200 by the communication unit 107. Or, it may be determined whether the power transmission is stopped.

In step S112, when it is determined that there is no desired power in the portable game machine 200, the process proceeds to step S113. In step S113, the mobile phone 100 stops the reception of the power from the portable game machine 200. If the power reception is stopped, the charging is stopped.

Meanwhile, in step S112, when it is determined that there is the desired remaining amount in the portable game machine 200, the process proceeds to step S114. In step S114, it is determined whether the charging is completed. The sensor 103 of the mobile phone 100 measures the remaining amount of the battery 104 and the control unit 106 determines whether the charging is completed on the basis of a measured value. When the entire capacity of the battery 104 can be charged, the completion of the charging may be determined and when the predetermined capacity of the entire capacity, that is, the capacity (previously set capacity) necessary for an account function is charged, the completion of the charging may be determined.

If the completion of the charging is determined when the capacity necessary for the account function is charged, a message or a warning to urge the user to charge the entire capacity may be output thereafter.

In step S114, when it is determined that the charging is completed, the charging process is terminated. When the charging process is terminated, the notification of the termination of the charging process is transmitted to the power transmission origin of the power. Meanwhile, in step S114, when it is determined that the charging is not completed, the process proceeds to step S115. In step S115, timing is performed with a variable timer. In step S116, all of the power receptions are stopped. The processes in steps S115 and S116 will be further described.

The variable timer has a function for clocking a predetermined time. The variable timer is configured to change the clocked time in consideration of the following state. The process proceeds to step S115. A situation in which the timing is performed with the variable timer is a state in which the power is received from another device and the charging is performed. The mobile phone 100, the portable game machine 200, and the personal computer 300 may be put in a bag and carried.

In this state, a positional relation illustrated in FIG 3 may change. That is, in the example illustrated in FIG 3, the portable game machine 200 is located at the position close to the mobile phone 100. However, this state may be changed to a state in which the personal computer 300 is located at the position close to the mobile phone 100. If the positional relation changes, the transmission efficiency changes.

By using the structure that can correspond to the change of the transmission efficiency due to the change of the positional relation, the charging efficiency can be improved. For example, when the mobile phone 100 receives the power from the portable game machine 200 and performs the charging, if the charging is continuously performed even though the position of the portable game machine 200 is changed to the position distant from the mobile phone 100, the transmission efficiency becomes low. Nevertheless, the charging may be continuously performed. However, by detecting the change in the transmission efficiency and controlling the charging according to the detected situation, the charging can be prevented from being continuously performed in a state in which the transmission efficiency is low, the power transmission can be switched to the power transmission from the device in a state in which the transmission efficiency is high, and the charging can be switched to the charging in a state in which the transmission efficiency is high. As a result, the charging can be performed continuously with high efficiency.

In order to regularly determine whether the power transmission and the power reception fixed at that time are in an optimal state in consideration of the above circumstances, the timing is performed with the variable timer. If the timing is performed with the variable timer and the predetermined time passes, all of the power receptions are stopped in step S116 and the process returns to step S102. If the process proceeds to step S102 and the following process is executed again, the transmittable power amount is calculated again and the power transmission origin is determined according to the value of the transmittable power amount. Therefore, the optimal transmission origin can be detected regularly by providing the variable timer.

As such, if the timing is performed with the variable timer and the predetermined time passes, the optimal power transmission origin can be detected and the charging can be performed with high efficiency because the power transmission origin is detected again. However, if the detection is performed frequently again, the power of each terminal may be consumed in the detection. That is, in step S102 or step S106, the temporary power transmission is performed in the portable game machine 200 or the personal computer 300, because the request for temporary power transmission is output to the portable game machine 200 or the personal computer 300.

The temporary power transmission is set as the power transmission for the short time in which the power is not consumed. However, if the number of times that the temporary power transmission is performed increases, the power may be gradually consumed. Therefore, it is preferable that the number of times that the temporary power transmission is performed, that is, the length of the time that is clocked by the variable timer, be approximately set. The appropriate setting is setting in which the change can be detected as early as possible and the temporary power transmission is minimized when the transmission efficiency changes.

Therefore, when it is determined that the state is stable and the distance between the terminals rarely changes, the variable timer functions as a timer that clocks a relatively long time, and when it is determined that the state is unstable and the distance between the terminals changes, the variable timer functions as a timer that clocks a relatively short time. In other words, when the transmission efficiency is stable (change is small), the long time is clocked and when the transmission efficiency is unstable (change is severe), the short time is clocked.

As a method of determining the clocking time, for example, if the stored reception power and the currently measured reception power are compared with each other and the difference is small, it is determined that the positional relation between the terminals does not change and a state is stable, and a next clocking time by the variable timer is set to a long time. In addition to the reception power, the transmittable power amount or the transmission efficiency can be set as information used at the time of the determination.

The description returns to step S110 of the flowchart of FIG 5. In step S110, when it is determined that the transmittable power amount satisfies the condition of personal computer > portable game machine, the process proceeds to step S117. In step S117, the transmission of the power from the personal computer 300 is permitted and the transmission of the power from the personal computer 300 starts. In addition, the reception of the power from the personal computer 300 starts and the charging starts.

In step S118, it is determined whether there is the desired remaining amount in the personal computer 300. When it is determined that there is not the desired remaining amount, the process proceeds to step S119 and the reception of the power from the personal computer 300 is stopped. Meanwhile, in step S118, when it is determined that there is the desired remaining amount in the personal computer 300, the process proceeds to step S114. Because the processes of step S114 and the following steps have already been described, the description thereof is omitted. Because the processes of steps S117 to S119 are basically the same as the processes of steps S111 to S113, the detailed description is appropriately omitted.

According to the processes of the flowcharts illustrated in FIGS. 4 and 5, when the remaining amount of the battery of the device of the power transmission origin has become the predetermined value or less, the power transmission is stopped. For example, when the portable game machine 200 becomes the power transmission origin and it is determined that there is no desired remaining amount in the portable game machine 200 in step S 112, the process proceeds to step S113, the reception of the power from the portable game machine 200 is stopped, and the process ends.

In the case of the above state, because the charging is not completed and there remains a choice of the personal computer 300 as the power transmission origin, the charging may not be stopped, the power transmission origin may be switched to the personal computer 300, and the charging may be continuously performed. As such, when the transmission of the power from one power transmission origin is stopped, the power transmission origin may be switched to another power transmission origin and the charging may be continuously performed.

[Process of the Power Transmission Side]

Next, when the battery of the mobile 100 is consumed and the charging is needed in FIG 3, a process that is executed by each of the portable game machine 200 becoming an object of the device of the power transmission side and the personal computer 300 will be described with reference to the flowchart illustrated in FIG 6. Because the same process is executed by the portable game machine and the personal computer 300, the portable game machine 200 is exemplified and the description is continuously given.

In step S151, the control unit 206 of the portable game machine 200 determines whether an authentication request is received from other device through the communication unit 207. A waiting state is maintained until it is determined that the authentication request is received. When it is determined that the authentication request is received, the process proceeds to step S152. In step S152, if the authentication is normally performed, information regarding the transmission power and the remaining amount is transmitted by the communication unit 207 and the power is transmitted by the power transmission control unit 202. The power transmission is the temporary power transmission.

In step S153, it is determined whether the request for power transmission start is received. When the mobile phone 100 is selected as the power transmission origin, a notification of the permission for power transmission from the mobile phone 100 to the portable game machine 200 is transmitted in step S111 (refer to FIG 5). In step S153, it is determined whether the notification is received. In step S153, a waiting state is maintained until it is determined that the notification of the power transmission start is received in step S153. When it is determined that the notification of the power transmission start is received, the process proceeds to step S154.

In step S154, the power transmission starts. If the power transmission starts, the control unit 206 of the portable game machine 200 monitors the remaining amount of its battery 204 through the sensor 203 and determines whether the remaining amount has become the desired value or less. The desired value is set to a value equal to or larger than the remaining amount that is necessary when the portable game machine 200 performs a minimum operation. In step S155, when it is determined that the remaining amount is not the desired remaining amount or less, the process proceeds to step S156.

In step S156, it is determined whether the notification of the charging completion is received from the power transmission destination. This determination is a process that corresponds to the notification output when it is determined that the charging is completed in the process of step S114 executed by the mobile phone 100. In step S156, when it is determined that the notification of the charging completion is not received from the power transmission destination, the process proceeds to step S157.

In step S157, it is determined whether the notification of the transmission stop is received. This determination is a process that corresponds to the notification output when the process for stopping all of the power transmissions is executed, in the process of step S116 executed by the mobile phone 100. In step S157, when it is determined that the notification of the stop of the power transmission is not received, the process returns to step S155 and the following processes are repeated. In this case, in a state in which a power transmission state is maintained, the processes of step S155 and the following steps are executed.

When it is determined that the capacity of the battery 204 has become the desired remaining amount or less in step S155, it is determined that the notification of the charging completion is received from the power transmission destination (mobile phone 100) in step S156, or when it is determined that the notification of the power transmission stop is received in step S157, the process proceeds to step S158. In step S158, the power transmission is stopped.

In the device that is set to the power transmission origin, in this case, the portable game machine 200, because the above process is executed, the power transmission is performed with respect to the mobile phone 100. In the device that is not set to the power transmission origin, in this case, the personal computer 300, because the notification of the power transmission start is not received, it is determined that the notification of the power transmission start is not received in step S153 and the following processes are not continuously executed. In this state, because the authentication request is output again in the mobile phone 100, it is determined that the authentication request is received in step S151 and the following processes are executed. As such, because the processes according to the flowchart of FIG 6 are executed in the device of the side not becoming the power transmission origin, coping with the switching of the power transmission origin is enabled.

[Second Embodiment]

Next, the second embodiment will be described. In the first embodiment, the mobile phone 100 and the portable game machine 200 perform the power transmission and the power reception in a one-to-one relation and the mobile phone 100 and the personal computer 300 perform the power transmission and the power reception in a one-to-one relation. In the second embodiment, an example of the case in which the mobile phone 100 receives the power transmitted from the personal computer 300 through the portable game machine 200 when the mobile phone 100 needs to perform the charging will be described.

Referring to FIG 1 again, the terminal 10 and the terminal 20 are apart from each other by the distance A, the terminal 10 and the terminal 30 are apart from each other by the distance B, and the distance A is shorter than the distance B. In this state, preferably, the terminal 10 needs to perform the charging and receives the power from the terminal 20, in terms of the transmission efficiency. However, a situation where the remaining amount of the battery of the terminal 20 is small and the power transmission is disabled is considered. At this time, the terminal 30 has the large remaining amount and can transmit the power.

In this case, the power is transmitted from the terminal 30 to the terminal 20. The terminal 20 receives the power from the terminal 30 and transmits the received power to the terminal 10. The terminal 10 receives the power from the terminal 20 and performs the charging. That is, the power transmission from the terminal 30 is performed with respect to the terminal 10 through the terminal 20. If the power transmission is performed directly from the terminal 30 to the terminal 10, the transmission efficiency is low, because the terminal 30 and the terminal 10 are apart from each other by the distance B. However, because the terminal 20 and the terminal 10 are apart from each other by the distance A, the transmission efficiency is high. Because the terminal 20 and the terminal 30 are apart from each other by the distance shorter than the distance B, the transmission efficiency is higher than the transmission efficiency when the terminal 30 transmits the power directly to the terminal 10 apart from the terminal 30 by the distance B. Therefore, if the power is transmitted from the terminal 30 to the terminal 10 through the terminal 20, the power transmission and the power reception are performed with high efficiency and the charging is performed.

Hereinafter, specific examples of the terminal 10, the terminal 20, and the terminal 30 will be described in detail. FIG 7 is a diagram illustrating a configuration example of the case in which the terminal 10 illustrated in FIG 1 is the mobile phone, the terminal 20 is the portable game machine, and the terminal 30 is the personal computer. The structure illustrated in FIG 7 is basically the same as the structure illustrated in FIG 3. In FIG 7, the same components as those of FIG 3 are denoted by the same reference numerals as those of FIG 3 and the redundant description is appropriately omitted.

A mobile phone 100 of FIG 7 is the same as the mobile phone 100 of FIG 3. A personal computer 300 of FIG 7 is the same as the personal computer of FIG 3. A portable game machine 400 of FIG 7 is configured by adding a coil 401, a power reception control unit 402, and a sensor 403 to the portable game machine 200 illustrated in FIG 3. The portable game machine 400 illustrated in FIG 7 is different from the portable game machine 200 illustrated in FIG 3 in that the portable game machine 400 has a power transmission function and a power reception function. As such, because the portable game machine 400 has the power transmission function and the power reception function, the portable game machine 400 receives the power from another device and performs the charging or transmits the power to another device.

In the portable game machine 400 illustrated in FIG 7, the coil 201, the power transmission control unit 202, and the sensor 203 that execute a process regarding the power transmission and the coil 401, the power reception control unit 402, and the sensor 403 that execute a process regarding the power reception are provided separately. However, the components may be configured for common use. For example, the portable game machine 400 may include the coil 201, the power transmission control unit 202, and the sensor 203 and may not include the coil 401, the power reception control unit 402, and the sensor 403, and the power transmission control unit 202 may control the power reception. As will be described below, when the power reception and the power transmission are performed by time sharing, if the power transmission control unit 202 (or the power reception control unit 402) is provided as the control unit to control the power reception and the power transmission by time sharing, the same structures may not be provided by two sets.

[Process of the Power Reception Side]

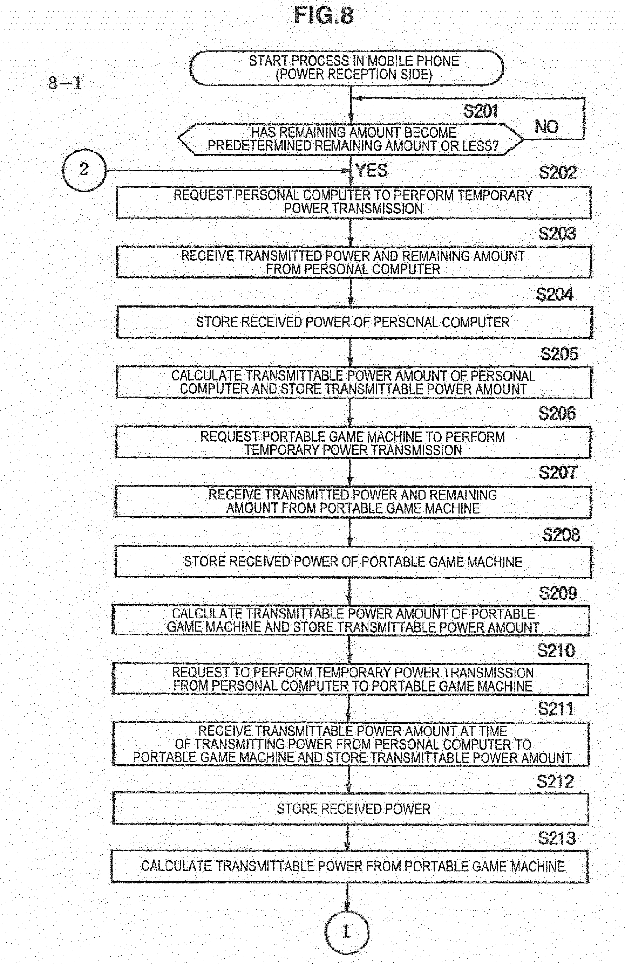

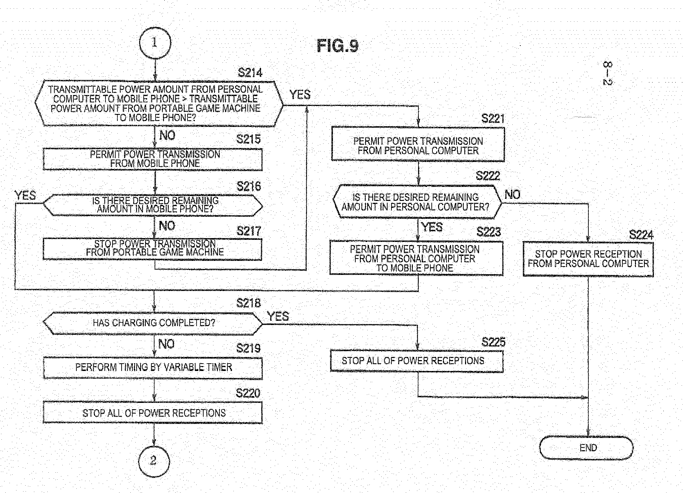

Next, a process that is executed by the mobile phone 100 when the battery of the mobile phone 100 is consumed and the charging needs to be performed in FIG 7 will be described with reference to flowcharts of FIGS. 8 and 9.

Because processes of steps S201 to S209 are the same as the processes of steps S101 to S109 of the flowchart illustrated in FIG 4, the description thereof is omitted. The mobile phone 100 executes the processes of steps S201 to S209, so that the mobile phone 100 calculates the transmittable power amount when the power is received from the portable game machine 400 and stores the transmittable power amount and calculates the transmittable power amount when the power is received from the personal computer 300 and stores the transmittable power amount.

The mobile phone 100 executes the processes for calculating the transmittable power amount when the power is received from the personal computer 300 through the portable game machine 400 and storing the transmittable power amount, in steps S210 to S213. In step S210, a request for temporary power transmission is output from the personal computer 300 to the portable game machine 400.

For example, an instruction is output from the mobile phone 100 to the personal computer 300 to perform the temporary power transmission with respect to the portable game machine 400, and the temporary power transmission is performed from the personal computer 300 to the portable game machine 400 on the basis of the instruction. In addition, an instruction is output from the mobile phone 100 to the portable game machine 400 to perform the temporary power transmission with respect to the personal computer 300, the portable game machine 400 outputs the request for temporary power transmission to the personal computer 300 on the basis of the instruction, and the temporary power transmission from the personal computer 300 is performed.

The temporary power transmission is performed from the personal computer 300 to the portable game machine 400 and the portable game machine 400 can calculate the transmittable power amount when the power is received from the personal computer 300. The temporary power transmission is performed under the control of the power reception control unit 402 of the portable game machine 400. In step S211, the communication unit 107 of the mobile phone 100 receives the transmittable power amount when the power transmitted from the communication unit 207 of the portable game machine 400 through the antenna 208 is transmitted from the personal computer 300 to the portable game machine 400 and stores the transmittable power amount.

In step S212, the received power is stored. The stored received power is power that is transmitted from the personal computer 300 through the portable game machine 400 and is received by the mobile phone 100. In step S213, the transmittable power amount when the power is transmitted from the personal computer 300 through the portable game machine 400 is calculated and stored.

In step S214, it is determined whether the transmittable power amount when the power is transmitted from the personal computer 300 to the mobile phone 100 is larger than the transmittable power amount when the power is transmitted from the portable game machine 400 to the mobile phone 100. In step S214, when it is determined that the transmittable power amount when the power is transmitted from the personal computer 300 to the mobile phone 100 is smaller than the transmittable power amount when the power is transmitted from the portable game machine 400 to the mobile phone 100, the process proceeds to step S215. In step S215, the power transmission from the portable game machine 400 is permitted and the power transmission from the portable game machine 400 starts.

If the power reception starts and the charging starts, it is determined whether there is the desired remaining amount in the portable game machine 400 in step S216. When it is determined that there is the desired remaining amount, the charging is continuously performed and the process proceeds to step S218. In step S218, it is determined whether the charging is completed. In step S218, when it is determined that the charging is not completed, the process proceeds to step S219.

In step S219, if the timing is performed with the variable timer for a predetermined time and the predetermined time passes, the process proceeds to step S220 and all of the power receptions are stopped. The processes of steps S215 to S220 (excluding the process of step S217) are executed in the same manner as the processes of steps S111 to S116 (excluding the process of step S113) of FIG. 7.

Meanwhile, in step S216, when it is determined that there is no desired remaining amount in the portable game machine 400, the process proceeds to step S217. In step S217, the power transmission from the portable game machine 400 is stopped. If the power transmission from the portable game machine 400 is stopped, the process proceeds to step S221. In step S221, the power transmission from the personal computer 300 is permitted. The process of step S221 is executed when it is determined that the transmittable power amount when the power is transmitted from the personal computer 300 to the mobile phone 100 is larger than the transmittable power amount when the power is transmitted from the portable game machine 400 to the mobile phone 100 in step S214.

In step S221, if the power transmission from the personal computer 300 is permitted, the power transmission from the personal computer 300 to the mobile phone 100 starts. In step S222, it is determined whether there is the desired remaining amount in the personal computer 300. When it is determined that there is the desired remaining amount, the process proceeds to step S223. In step S223, the power transmission from the personal computer 300 to the portable game machine 400 is permitted.

In this case, in step S221, the power transmission from the personal computer 300 is permitted. In step S223, the power transmission from the personal computer 300 to the portable game machine 400 is permitted. Therefore, the power is transmitted from the personal computer 300 to the portable game machine 400 and the power transmission is performed in the mobile phone 100 through the portable game machine 400. The portable game machine 100 receives the power supplied indirectly from the personal computer 300 and performs the charging. If the charging is performed, the process proceeds to step S218. Because the processes of step S218 or the following steps have already been described, the description thereof is omitted.

Meanwhile, in step S222, when it is determined that there is no desired remaining amount in the personal computer 300, the process proceeds to step S224 and the power transmission from the personal computer 300 is stopped. Then, the charging process is terminated.

Meanwhile, in step S218, when it is determined that the charging in the mobile phone 100 is completed, the process proceeds to step S225. In step S225, all of the power receptions are stopped. "All of the power receptions" refers to a state in which the portable game machine 400 receives the power from the personal computer 300 and the mobile phone 100 receives the power from the portable game machine 400, when the power transmission from the personal computer 300 is performed through the portable game machine 400. In this case, "all of the power receptions" means that two power receptions of the power reception of the portable game machine 400 and the power reception of the mobile phone 100 are stopped. If all of the power receptions are completed, the charging process is terminated. When the power reception is stopped, a notification to instruct that the power transmission be stopped may be output from the mobile phone 100 to the personal computer 300 or the portable game machine 400.

As such, if the portable game machine 400 relays the power transmission from the personal computer 300 and performs the power transmission with respect to the mobile phone 100, the power transmission and the power reception can be performed with high efficiency and the charging can be performed, even when the personal computer 300 and the mobile phone 100 are apart from each other.

In this case, a process that is executed by the portable game machine 400 functioning as a repeater of the transmitted power will be described with reference to FIG 7 again. When the portable game machine 400 transmits the power of the battery 204 to the mobile phone 100, the predetermined power is supplied from the battery 204 to the power transmission control unit 202 through the sensor 203. In addition, the power transmission is performed with respect to the mobile phone 100, under the control of the power transmission control unit 202.

When the portable game machine 400 functions as the repeater to transmit the power from the personal computer 300 to the mobile phone 100, first, the portable game machine 400 receives the power from the personal computer 300 by the power reception control unit 402 and supplies the power to the battery 204 through the sensor 403 to charge the battery 204. The charged power is transmitted to the mobile phone 100 by the power transmission control unit 202.

When the frequencies used in the power transmission and the power reception are the same, the power reception and the power transmission are performed by time sharing. For example, when the power transmission frequency that is used when the power is transmitted from the personal computer 300 to the portable game machine 400 is 13.56 MHz and the power transmission frequency that is used when the power is transmitted from the portable game machine 400 to the mobile phone 100 is 13.56 MHz, if the power transmission and the power reception are simultaneously performed in the portable game machine 400, this may cause interference. If the interference is caused, the transmission efficiency of the power is deteriorated.

Therefore, when the interference is likely to be caused, the interference can be prevented by performing the power transmission and the power reception by time sharing and the transmission efficiency of the power can be prevented from being deteriorated. Even if the interference is generated, if the transmission efficiency is not greatly deteriorated, the power reception and the power transmission can be simultaneously performed.

[Other Structure of the Repeater]

When the portable game machine 400 functions as the repeater, as illustrated in FIG 7, if the device (in this case, the mobile phone 100) becoming the power transmission destination is on the side of the coil 201 for the power transmission and the device (in this case, the personal computer 300) becoming the power transmission origin is on the side of the coil 401 for the charging, the power transmission and the power reception are performed with high efficiency. However, if the device (in this case, the mobile phone 100) becoming the power transmission origin is on the side opposite to the side of the coil 201 for the power transmission (the side of the coil 401 for the charging) and the device (in this case, the personal computer 300) becoming the power transmission origin is on the side opposite to the side of the coil 401 for the power reception (the side of the coil 201 for the power transmission), efficiency of the power transmission and the power reception is deteriorated.

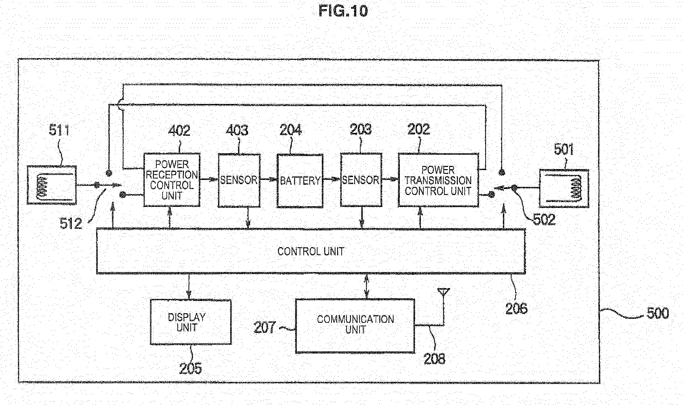

According to a positional relation among the individual devices of the mobile phone 100, the portable game machine 400, and the personal computer 300, the individual devices are not disposed at positions suitable for the power transmission and the power reception. Therefore, a structure of the portable game machine that has a function of adjusting positional relations of the coils, such that the coil for the power transmission is positioned in the vicinity of the device of the power transmission destination and the coil for the power reception is positioned in the vicinity of the device of the power transmission origin, regardless of the positional relation of the device of the power transmission origin and the device of the power transmission destination, is illustrated in FIG 10.

In a portable game machine 500 illustrated in FIG 10, the coil 201 is replaced with a coil 501, the coil 401 is replaced with a coil 511, and switches 502 and 512 are additionally provided, as compared with the portable game machine 400 illustrated in FIG 7. The other structure is the same as that of the portable game machine 400 illustrated in FIG 7.

The coil 501 functions as the coil for the power reception or the coil for the power transmission. Likewise, the coil 511 functions as the coil for the power reception or the coil for the power transmission. By connection of the switches 502 and 512, it is controlled whether each of the coil 501 and the coil 511 functions as the coil for the power reception or the coil for the power transmission.

One end of the switch 502 is connected to the coil 501 and the other end thereof is connected to the power transmission control unit 202 or the power reception control unit 402. Likewise, one end of the switch 512 is connected to the coil 511 and the other end thereof is connected to the power transmission control unit 202 or the power reception control unit 402. The connection of the switch 502 and the switch 512 is controlled by the control unit 206.

If the switch 502 is connected to the power transmission control unit 202, the coil 501 functions as the coil for the power transmission because the coil 501 is connected to the power transmission control unit 202. If the switch 502 is connected to the power reception control unit 402, the coil 501 functions as the coil for the power reception because the coil 501 is connected to the power reception control unit 402. For example, when the device becoming the power transmission object is positioned in the vicinity of the coil 501, the switch 502 and the power transmission control unit 202 are connected such that the coil 501 functions as the coil for the power transmission. For example, when the device becoming the power transmission origin is positioned in the vicinity of the coil 501, the switch 502 and the power reception control unit 402 are connected such that the coil 501 functions as the coil for the power reception.

Likewise, if the switch 502 is connected to the power transmission control unit 202, the coil 511 functions as the coil for the power transmission because the coil 511 is connected to the power transmission control unit 202. If the switch 512 is connected to the power reception control unit 402, the coil 511 functions as the coil for the power reception because the coil 511 is connected to the power reception control unit 402. For example, when the device becoming the power transmission object is positioned in the vicinity of the coil 511, the switch 512 and the power transmission control unit 202 are connected such that the coil 511 functions as the coil for the power transmission. For example, when the device becoming the power transmission origin is positioned in the vicinity of the coil 511, the switch 512 and the power reception control unit 402 are connected such that the coil 511 functions as the coil for the power reception.

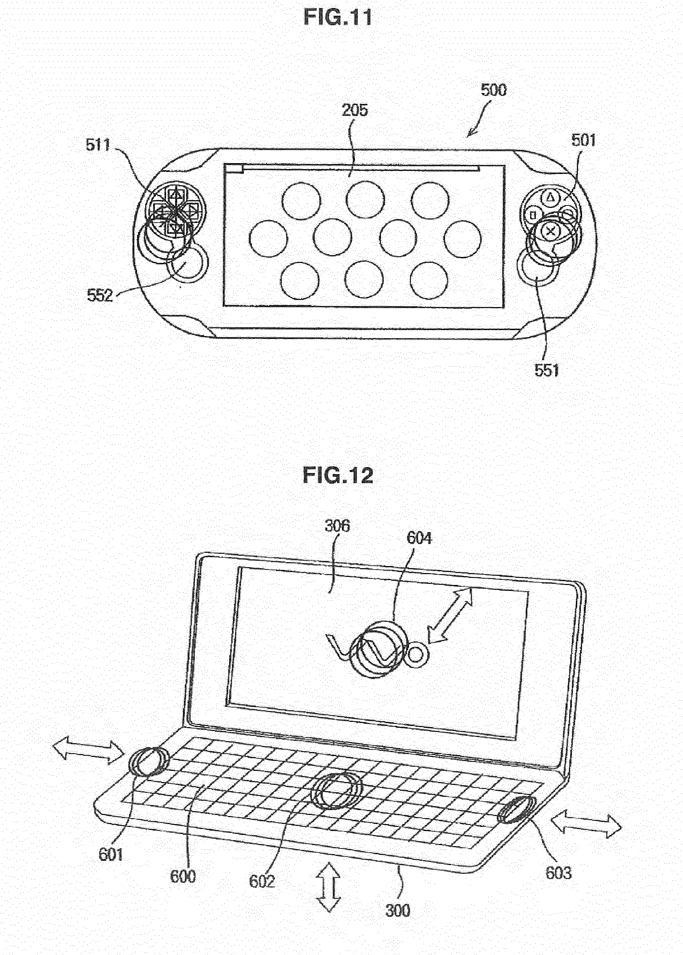

The coil 501 and the coil 511 are provided at the positions illustrated in FIG 11. FIG 11 is a diagram illustrating a configuration example of the external appearance of the portable game machine 500. On one surface of the portable game machine 500, a display unit 205 is provided and operation units 551 and 552 are provided. The coil 501 is provided at the side of the operation unit 551 and the coil 511 is provided at the side of the operation unit 552. As illustrated in FIG 11, the coil 501 and the coil 502 are provided at the positions of the operation unit 551 and the operation unit 552 provided on both ends of the portable game machine 500 in a longitudinal direction, respectively. In this example, the coils 501 and 511 are provided at the positions of the operation units 551 and 552. However, the positions of the coils may not be determined according to the positional relation with the operation units and the coils may be provided in other components.

The coil 501 and the coil 511 are preferably disposed at positions apart from each other. Therefore, as in the portable game machine 500 illustrated in FIG 11, when there is a longitudinal direction, the coils are preferably disposed at positions apart from each other in the longitudinal direction. The number of coils that are provided in one device is not limited to two and may be two or more as will be described with reference to FIG 12. In FIG 11, the coils 501 and 511 are illustrated for easier understanding. However, in an actual product, the coils 501 and 511 may be included out of sight in the portable game machine 500.

As such, when the two coils 501 and 511 are provided and the switches 502 and 512 corresponding to the coils are provided, the power reception and the power transmission can be performed by time sharing by controlling switching timing of the switches 502 and 512. The control to realize the time sharing may be performed by controlling each of the power transmission control unit 202 and the power reception control unit 402 by the control unit 206.

Both the coil 501 and the coil 511 can be connected to the power transmission control unit 202 and the power can be transmitted simultaneously to the device positioned in the vicinity of the coil 501 and the device positioned in the vicinity of the coil 511. In addition, both the coil 501 and the coil 511 can be connected to the power reception control unit 402, the power can be received simultaneously from the device positioned in the vicinity of the coil 501 and the device positioned in the vicinity of the coil 511, and the battery 204 can be charged.

FIG 12 is a diagram illustrating an example of the case in which a plurality of coils are provided in a personal computer 300. The personal computer 300 illustrated in FIG 12 is a personal computer that is generally called a notebook computer and the personal computer 300 is illustrated in an opened state. A display unit 306 is provided on one surface of the personal computer 300 in the opened state and a keyboard 600 is provided on the other surface thereof. A coil 601, a coil 602, and a coil 603 are provided at both ends and the center of the keyboard 600, respectively. A coil 604 is provided in a portion of the display unit 306.

The coils 601 to 604 are provided in the personal computer 300 and are not viewed by the user. Each of arrows of FIG 12 shows an optimal direction when each of the coils 601 to 604 receives the power and transmits the power.

The coils 601 and 603 are provided on both ends of the personal computer 300 in a longitudinal direction. This is because the coils are preferably apart from each other, similar to the case of the portable game machine 500 described above. If the personal computer 300 is compared with the portable game machine 500, the mobile phone 100 that becomes the power reception object may be positioned at the sides, an upper portion, and a lower portion of the personal computer 300, because a size of the personal computer 300 is large.

The upper portion of the personal computer 300 is the back side of the display unit 306 and is a surface that generally becomes a top surface in a closed state, and the device such as the mobile phone 100 that becomes the power reception object or the power transmission object may be positioned at the surface of the personal computer 300. In consideration of the above circumstance, the coil 604 is provided in the portion of the display unit 306.

Likewise, the lower portion of the personal computer 300 is the back side of the keyboard 600 and is a surface that generally becomes a bottom surface in the closed state, and the device such as the mobile phone 100 that becomes the power reception object or the power transmission object may be positioned at the surface of the personal computer 300. This state may be generated when the personal computer 300 or the mobile phone 100 is put in a bag in a state in which the user is not aware the upper and lower portions. In consideration of the above circumstances, the coil 602 is provided in the portion of the keyboard 600.

FIG 12 illustrates the example of the case in which the four coils 601 to 604 are provided in one device. However, four or more coils may be provided in one device. As such, when the plurality of coils are provided, switches of the number that is equal the number of coils are provided. That is, the switches that are connected to the coils are provided, the switches are connected to the power transmission control unit or the power reception control unit, and the coils are used as the coils for the power reception or the coils for the power transmission.

The two switches are provided, one end of one of the two switches is connected to the power transmission control unit, and the other end thereof can be connected selectively to any one of the plurality of coils. As a result, one of the plurality of coils can be used as the coil for the power transmission. Likewise, one end of one of the two switches can be connected to the power reception control unit, and the other end thereof can be connected selectively to any one of the plurality of coils. As a result, one of the plurality of coils can be used as the coil for the power reception.

As such, when the plurality of coils are included in one device, a control operation may be performed such that coils of the plurality of coils are used as coils for the power reception and the power is received simultaneously from the plurality of devices. In addition, a control operation may be performed such that coils of the plurality of coils may be used as coils for the power transmission and the power may be transmitted simultaneously from the plurality of devices.

In order to improve power transmission efficiency or power reception efficiency in each of the coils 601 to 604, a coil having a changed angle or a movable coil may be disposed in the vicinity of each coil. For example, when the power transmission is performed, the coils 601 to 604 may be sequentially switched, a mechanism in which the coil having the highest transmission efficiency of the power is detected may be provided, and the power transmission may be performed using the coils having high transmission efficiency.

As such, by providing the plurality of coils in one device, the transmission efficiency of each of the power transmission and the power reception can be improved. The function as the repeater of the power can be improved.

Each of the plurality of coils may be configured such that the power transmission or the power reception is performed using the same power transmission frequency, for example, a power transmission frequency of 13.56 MHz or the power transmission or the power reception is performed using different power transmission frequencies or selectively switching the different power transmission frequencies.

For example, when the power transmission or the power reception is performed using the different power transmission frequencies, the power transmission or the power reception is performed using the power transmission frequency that can be used by the power transmitting or power receiving side. Even when the power transmission or the power reception is performed by selectively switching the different power transmission frequencies, the power transmission or the power reception is performed using the power transmission frequency that can be used by the power transmitting or power receiving side. Next, the case in which the different power transmission frequencies are selectively switched will be described.

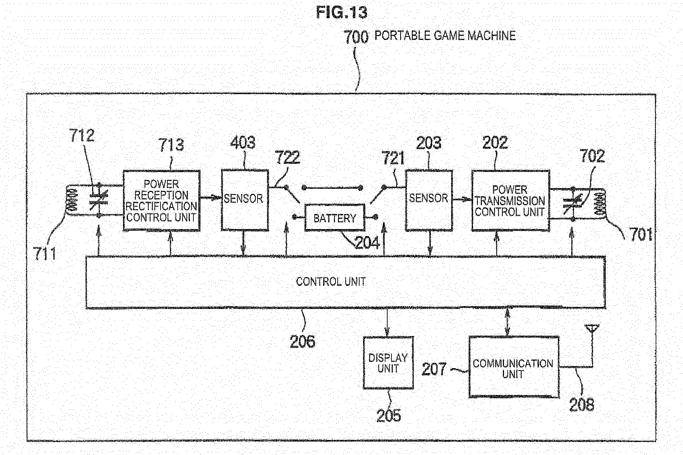

FIG 13 is a diagram illustrating a configuration example of a portable game machine that performs the power transmission or the power reception by selectively switching the different frequencies. In a portable game machine 700 illustrated in FIG 13, a coil 701 and a capacitor 702 are provided instead of the coil 201 and a coil 711 and a capacitor 712 are provided instead of the coil 401, as compared with the portable game machine 400 illustrated in FIG 7. A switch 721 is provided between the sensor 203 and the battery 204 and a switch 722 is provided between the sensor 403 and the battery 204. The power reception control unit 402 in the portable game machine 400 becomes a power reception rectification control unit 713 in the portable game machine 700.

The coil 701 and the capacitor 702 are connected in parallel. The coil 701 and the capacitor 702 are connected to the power transmission control unit 202 and the capacitor 702 becomes a variable capacitor. By changing the capacity of the capacitor 702, a resonance frequency can be changed. The control unit 206 controls the capacitor 702 and sets a frequency to a power transmission frequency matched with a frequency of the device performing the power transmission. The frequency is set by receiving information transmitted from the device of the power reception side by the communication unit 207, analyzing the information by the control unit 206, and controlling the capacitor 702 on the basis of the analysis.

Likewise, the coil 711 and the capacitor 712 are connected in parallel. The coil 711 and the capacitor 712 are connected to the power reception rectification control unit 713 and the capacitor 712 becomes a variable capacitor. By the changing the capacity of the capacitor 712, a resonance frequency can be changed.

The control unit 206 controls the capacitor 712 and sets a frequency to a frequency matched with a power transmission frequency of the device performing the power transmission. The frequency is set by receiving information transmitted from the device of the power transmission side by the communication unit 207, analyzing the information by the control unit 206, and controlling the capacitor 712 on the basis of the analysis. The power reception rectification control unit 713 controls the reception of the power from another device and performs a control operation to rectify the power according to necessity, convert the power into a direct current, and supply the direct current to the switch 722 through the sensor 403.

When the switch 721 transmits the power of the battery 204 to another device, the switch 721 is connected to the side connecting the battery 204 and the sensor 203. As such, if the switch 721 is connected, the power read from the battery 204 is supplied to the power transmission control unit 202 through the sensor 203 and is transmitted to another device under the control of the power transmission control unit 202. At this time, the capacity of the capacitor 702 is set such that a resonance frequency becomes a frequency at which the power transmission destination can receive the power, for example, 13.56 MHz.

When the switch 722 receives the power from another device and charges the battery 204, the switch 722 is connected to the side connecting the battery 204 and the sensor 403. As such, if the switch 722 is connected, the power that is transmitted from another device and is reception-controlled by the power reception rectification control unit 713 is supplied to the battery 204 through the sensor 403. When the power is supplied to the battery 204, the power reception rectification control unit 713 controls the power reception. However, the power reception rectification control unit 713 does not control the rectification. At this time, the capacity of the capacitor 712 is set such that a resonance frequency becomes a frequency at which the power transmission destination can transmit the power, for example, 27.12 MHz.

When both the switch 721 and the switch 722 are not connected to the battery 204 and the switch 721 and the switch 722 are connected, the sensor 203 and the sensor 403 are connected directly through the switch 721 and the switch 722. In this state, the power that is transmitted from another device and is received is rectified by the power reception rectification control unit 713 and converted into a direct current and the direct current is supplied to the power transmission control unit 202 through the sensor 403, the switch 722, the switch 721, and the sensor 203. By the power transmission control unit 202, the power transmission is performed with respect to the device of the power transmission object.

At this time, the resonance frequency by the coil 701 and the capacitor 702 becomes a frequency matched with the frequency of the device becoming the power transmission destination and the resonance frequency by the coil 711 and the capacitor 712 becomes a frequency matched with the frequency of the device of the power transmission origin. As such, because the frequency can be matched with the frequency of each of the power transmission destination and the power transmission origin, the power transmission and the power reception can be performed simultaneously.

In this case, the device (portable game machine 700) that can perform the power transmission and the power reception has been described. However, the device that sets the resonance frequency by the combination of the variable capacitor and the coil is not limited to the device that can perform the power transmission and the power reception. That is, the device that sets the resonance frequency can be applied to the device such as the mobile phone 100 that performs the power reception and can be applied to the device that performs the power reception by matching the frequency thereof with the power transmission frequency used when the device of the power transmission origin performs the power transmission. Instead of changing the capacity by the variable capacitor, by physically changing a coil winding interval or by providing a tab and changing inductance, the resonance frequency may be changed.

The portable game machine 700 illustrated in FIG 13 includes one coil 701 for the power transmission and one coil 712 for the power reception. As in the portable game machine 500 illustrated in FIG 11 or the personal computer 300 illustrated in FIG 12, the plurality of coils may be included. When the plurality of coils are included, as illustrated in FIG 10, the switches are provided, connection is switched, the coils suitable for the power transmission or the power reception are selected, and the transmission with high efficiency can be realized at all times

[Third Embodiment]

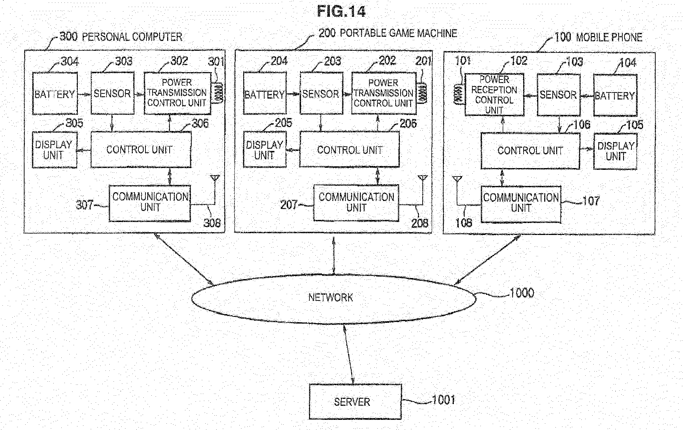

Next, the case in which a server is used will be described as the third embodiment. FIG 14 is a diagram illustrating a configuration example of a system that includes the server. A mobile phone 100, a portable game machine 200, a personal computer 300, and a server 1001 are connected to a network 1000.

The mobile phone 100, the portable game machine 200, and the personal computer 300 have the same structures as the mobile phone 100, the portable game machine 200, and the personal computer 300 illustrated in FIG 3, respectively. Therefore, authentication can be performed between the devices using Wi-Fi and the power transmission and the power reception can be performed as described above. However, when the authentication is performed using NFC used at a ticket wicket in a station, if a similar regular card is nearby, the authentication may not be performed. That is, even in a positional relation in which the devices are nearby and the authentication can be performed, a strong obstacle exists and the authentication may not be performed.

When the authentication is not performed directly between the devices, the authentication is performed through the server 1001. The authentication and the request for temporary power transmission are performed through the server 1001 and the temporary power transmission or the power transmission is performed between the nearby devices. Therefore, because processes executed by the mobile phone 100 when the mobile phone 100 needs to perform the charging are executed on the basis of the flowcharts of FIGS. 4 and 5, the difference with the processes described above will be described with reference to the flowcharts of FIGS. 4 and 5 again.

When it is determined that the remaining amount of the battery 104 has become the predetermined value or less in step S101 and the charging needs to be performed, the request for temporary power transmission is output to the personal computer 300 in step S102. The request for temporary power transmission is output to the server 1001 through the network 1000 and the server 1001 transmits the request for temporary power transmission to the personal computer 300.

The personal computer 300 receives the request for temporary power transmission received through the server 1001 and transmits information regarding a value of the transmission power and the remaining amount of the battery 304 to the mobile phone 100 through the server 1001. The information is received in step S 103 by the communication unit 107 of the mobile phone 100.

The personal computer 300 performs the temporary power transmission with respect to the mobile phone 100 under the control of the power transmission control unit 302. The temporary power transmission is the power transmission that is performed for only a short time, as described above. The temporarily transmitted power is received by the mobile phone 100 and the mobile phone 100 stores the power in step S104. Because the direct authentication is not performed and the authentication is performed through the server 1001 (information is exchanged), the personal computer 300 may not be positioned within a distance in which the power can be received. If the power is not received, the received power is stored as 0 and a process of a subsequent stage is executed.

In step S105, the transmittable power amount in the personal computer 300 is calculated and stored. When the received power is 0, a value of 0 is stored, because the transmittable power amount is calculated as 0.

As such, the authentication or the exchange of the information is performed indirectly through the server 1001 and the temporary power transmission (power transmission) is performed directly.

The same process is executed between the portable game machine 200 and the server. In step S106, the request for temporary power transmission through the server 1001 is output to the portable game machine 200. In step S107, information regarding the transmission power from the portable game machine 200 and the remaining amount is received through the server 1001. In step S108, the received power at the time of the temporary power transmission from the portable game machine 200 is stored. In step S109, the transmittable power amount in the portable game machine 200 is calculated.

In this way, the communication through the server 1001 and the direct temporary power transmission are performed. If the transmittable power amount in each device is calculated, the process proceeds to step S110 (refer to FIG 5). After step S110, the power transmission starts. However, because the process regarding the power transmission is the same as the process in the above case, the description thereof is omitted.

When the permission for power transmission is output to the portable game machine 200 in step S111, the notification from the portable game machine 200 to determine whether there is the desired remaining amount in the portable game machine 200 in step S112 is performed through the server 1001. When the permission for power transmission is output to the personal computer 300 in step S117, the notification from the personal computer 300 to determine whether there is the desired remaining amount in the personal computer 300 in step S112 is performed through the server 1001.

In this case, the processes are executed on the basis of the flowcharts illustrated in FIGS. 4 and 5. However, when the portable game machine 200 has a function as the repeater, the processes of the mobile phone 100 are executed on the basis of the flowcharts of FIGS. 8 and 9. Even when the processes are executed on the basis of the flowcharts illustrated in FIGS. 8 and 9, the processes are executed in the same manner as the above case, except that the authentication and the exchange of the information are performed through the server 1001. Therefore, the description thereof is omitted.

In this case, the server 1001 is described as the device that is relayed when the authentication is performed or the information is exchanged. However, the server 1001 may execute other processes. For example, a part of the processes based on the flowcharts of FIGS. 4 and 5 may be executed by the server 1001. As the part of the processes, for example, the request for charging may be received from the mobile phone 100 and the detection of the device that becomes the optimal power transmission origin may be performed by the server 1001. In addition, information to specify each device such as the MACs of the mobile phone 100, the portable game machine 200, and the personal computer 300 necessary for executing the processes and information such as the remaining amount of the battery, the power transmission efficiency between the devices, the power transmission frequency, and the power transmission method may be transmitted from each device to the server 1001, information can be registered previously in the server 1001, and the server 1001 may acquire the necessary information according to necessity.

[Other Structure]

The embodiments described above include the mobile phone, the portable game machine, and the personal computer, one of the three devices becomes the power reception object, and the other devices become the power transmission destinations. The present disclosure is not limited to being applied to the three devices and can be applied to the case in which there are three or fewer devices or three or more devices.

One device functions as the repeater. However, the present disclosure can be applied to the case in which one or more devices, for example, the two devices, function as the repeater.

As the contactless power transmission, the electromagnetic induction type has been described. However, the present disclosure can be applied to various contactless power transmissions such as a magnetic field resonance type or a technique using an electric wave. Because transmission efficiency of an actual use state is measured, an optimal transmission origin in all cases such as the transmission distance, a transmission angle, and efficiency deterioration due to a transmission shielding material between the transmissions can be requested.

In the embodiments described above, if the power transmission origin is determined, the power transmission starts at a next timing. The power transmission does not start immediately after the power transmission origin is determined and may start after a predetermined time passes. For example, in the mobile phone 100, when the user desires to decrease an influence of noise generated in the power transmission at timing when the power reception is anticipated, a control operation may be performed to delay the start of the power transmission.

In the embodiments described above, the power transmission efficiency is calculated by calculating the received power from the consumption current and the voltage received by the temporary power transmission and detected by the sensor. However, the received power may be calculated using a part of a battery manager embedded in a battery such as a smart battery.

In the embodiments described above, when the remaining amount of the battery decreases and becomes the predetermined value or less, the process such as the detection of the power transmission origin starts. However, the process may start when an operation member of each device operates as a trigger. In other words, the process regarding the charging may be started by methods other than the method of starting the process regarding the charging when the remaining amount of the battery has become the predetermined value or less.

In the embodiments described above, the direct-current (DC) devices such as the mobile phone, the portable game machine, and the personal computer have been described. However, the present disclosure is not limited to being applied to the above devices. For example, a device that is linked to a wall socket disposed on a wall may be included as one of the devices of the power transmission origins. For example, various devices that are put in a table, a kitchen, and a washroom in a home may be included as the devices of the power transmission origins or the devices of the power reception objects.

In the embodiments described above, the power transmission starts after the power transmission efficiency or the remaining amount is confirmed and at that time, the devices (including the device functioning as the repeater) of the power transmission origins are detected. However, if there is no possibility of interference occurring, the power may be transmitted from the device becoming one power transmission origin to the devices becoming the plurality of power reception objects and at that time, a path may be switched into a path having optimal transmission efficiency.

[Recording Medium]

The series of processes can be realized by hardware or software. When the series of processes is executed by software, a program forming the software is installed in a computer. In this case, examples of the computer include a computer that is embedded in dedicated hardware and a general-purpose personal computer in which various programs can be installed and various functions can be executed.

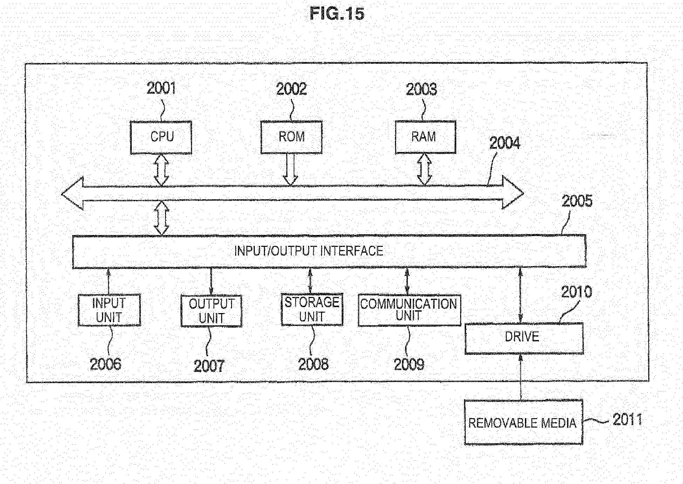

FIG 15 is a block diagram illustrating a configuration example of hardware of a computer in which the series of processes is executed by a program. In the computer, a central processing unit (CPU) 2001, a read only memory (ROM) 2002, and a random access memory (RAM) 2003 are connected mutually by a bus 2004. An input/output interface 2005 is further connected to the bus 2004. An input unit 2006, an output unit 2007, a storage unit 2008, a communication unit 2009, and a drive 210 are connected to the input/output interface 2005.

The input unit 2006 includes a keyboard, a mouse, and a microphone. The output unit 2007 includes a display and a speaker. The storage unit 2008 is configured using a hard disk or a nonvolatile memory. The communication unit 2009 is configured using a network interface. The drive 2010 drives a removable medium 2011 such as a magnetic disk, an optical disc, a magneto optical disc, or a semiconductor memory.

In the computer that has the above structure, the CPU 2001 loads the program stored in the storage unit 2008 to the RAM 2003 through the input/output interface 2005 and the bus 2004 and executes the program. As a result, the series of processes is executed.

The program that is executed by the computer (CPU 2001) can be recorded in the removable medium 2011 functioning as a package medium and may be provided. The program can be provided through wired or wireless transmission media, such as a local area network, the Internet, and digital satellite broadcasting.

In the computer, the program can be installed in the storage unit 2008 through the input/output interface 2005 by mounting the removable medium 2011 on the drive 2010. The program can be received by the communication unit 2009 through the wired or wireless transmission media and can be installed in the storage unit 2008. In addition, the program can be installed previously in the ROM 2002 or the storage unit 2008.

The program that is executed by the computer may be a program that is processed temporally according to the order described in the present disclosure or a program that is executed in parallel or at necessary timing such as when calling is performed.

In the present disclosure, a terminology of the system means an entire apparatus that is configured using plural devices.

It should be understood by those skilled in the art that various modifications, combinations, subcombinations and alterations may occur depending on design requirements and other factors insofar as they are within the scope of the appended claims or the equivalents thereof.

The present application contains subject matter related to that disclosed in Japanese Priority Patent Application JP 2011-090036 filed in the Japan Patent Office on April 14, 2011, the entire content of which is hereby incorporated by reference.

**Claims**

1.  A power control apparatus comprising:

      a calculating unit that calculates transmission efficiency of power from each of a plurality of devices when the power is received from one device of the plurality of devices; and

a control unit that controls power transmission from a device in which the transmission efficiency is high.

2. The power control apparatus according to claim 1, further comprising:

an acquiring unit that acquires information regarding a value of the power transmitted from each of the plurality of devices and a remaining amount of a battery; and
a measuring unit that receives the power from each of the plurality of devices and measures a value of the received power,

wherein the calculating unit divides the value of the received power measured by the measuring unit by the value of the transmitted power included in the information to calculate the transmission efficiency, and
wherein the control unit controls the power transmission from a device in which a value obtained by multiplying the remaining amount of the battery and the transmission efficiency is large.

3. The power control apparatus according to claim 1 or 2,
wherein a time after the power transmission is controlled by the control unit is clocked, the power transmission is stopped when a set time passes, and the transmission efficiency is calculated by the calculating unit again among the plurality of devices.

4. The power control apparatus according to claim 3,
wherein the clocking time is set long when the transmission efficiency is stable, and
the clocking time is set short when the transmission efficiency is unstable.

5. The power control apparatus according to one of the claims 1 to 4,
wherein a plurality of coils are provided, and
a coil that is located at a position close to the device performing the power transmission is used and the power transmission is performed.

6. The power control apparatus according to one of the claims 1 to 5,
wherein the power transmission is performed through a device performing power transmission and power reception.

7. The power control apparatus according to claim 6,
wherein, in the device performing the power transmission and the power reception, the power transmission and the power reception are performed by time sharing.

8. The power control apparatus according to one of the claims 1 to 7,
wherein a resonance frequency is set to a frequency used by a counterpart-side device performing the power transmission and the power transmission is performed.

9. The power control apparatus according to one of the claims 1 to 8,
wherein a communication is performed through a server connected to a network.

10. A power control method comprising:

calculating transmission efficiency of power from each of a plurality of devices when the power is received from one device of the plurality of devices; and
controlling power transmission from a device in which the transmission efficiency is high.

11. A program for causing a computer to execute a power control process,
wherein the power control process includes
calculating transmission efficiency of power from each of a plurality of devices when the power is received from one device of the plurality of devices; and
controlling power transmission from a device in which the transmission efficiency is high.

# FIG.1

# FIG.2

```
          ┌─────────────────────┐
          │    START POWER      │
          │  RECEPTION PROCESS  │
          └─────────────────────┘
                     │
                     ▼              S11
    ┌──────────────────────────────────┐
    │   OUTPUT REQUEST FOR TEMPORARY   │
    │        POWER TRANSMISSION        │
    └──────────────────────────────────┘
                     │
                     ▼              S12
    ┌──────────────────────────────────┐
    │      CALCULATE TRANSMITTABLE     │
    │          POWER AMOUNT            │
    └──────────────────────────────────┘
                     │
                     ▼              S13
    ┌──────────────────────────────────┐
    │       DETERMINE TERMINAL         │
    │  THAT HAS LARGEST TRANSMITTABLE  │
    │          POWER AMOUNT            │
    └──────────────────────────────────┘
                     │
                     ▼              S14
    ┌──────────────────────────────────┐
    │    RECEIVE TRANSMITTED POWER     │
    │       AND PERFORM CHARGING       │
    └──────────────────────────────────┘
                     │
                     ▼
          ┌─────────────────────┐
          │         END         │
          └─────────────────────┘
```

FIG.3

300 PERSONAL COMPUTER

304 BATTERY — 303 SENSOR — 302 POWER TRANSMISSION CONTROL UNIT — 301

305 DISPLAY UNIT — 306 CONTROL UNIT

307 — COMMUNICATION UNIT — 308

B

200 PORTABLE GAME MACHINE

A

204 BATTERY — 203 SENSOR — 202 POWER TRANSMISSION CONTROL UNIT — 201

205 DISPLAY UNIT — 206 CONTROL UNIT

207 — COMMUNICATION UNIT — 208

POWER TRANSMISSION

WIRELESS AUTHENTICATION

100 MOBILE PHONE

101 — 102 POWER RECEPTION CONTROL UNIT — 103 SENSOR — 104 BATTERY

106 CONTROL UNIT — 105 DISPLAY UNIT

108 — COMMUNICATION UNIT — 107

## FIG.4

4-1

```
       ┌─────────────────────────────────────┐
       │  START PROCESS IN MOBILE PHONE       │
       │     (POWER RECEPTION SIDE)           │
       └─────────────────────────────────────┘
                        │
                        ▼                    S101
       ╱─────────────────────────────────────╲      NO
      ╱   HAS REMAINING AMOUNT BECOME          ╲────────┐
      ╲ PREDETERMINED REMAINING AMOUNT OR LESS?╱        │
       ╲─────────────────────────────────────╱         │
   ②─────────────►   │ YES          S102               │
       ┌─────────────────────────────────────┐         │
       │ REQUEST PERSONAL COMPUTER TO PERFORM │         │
       │    TEMPORARY POWER TRANSMISSION      │         │
       └─────────────────────────────────────┘         │
                        │              S103             │
       ┌─────────────────────────────────────┐         │
       │ RECEIVE TRANSMITTED POWER AND REMAINING│       │
       │    AMOUNT FROM PERSONAL COMPUTER     │         │
       └─────────────────────────────────────┘         │
                        │              S104             │
       ┌─────────────────────────────────────┐         │
       │ STORE RECEIVED POWER OF PERSONAL COMPUTER│     │
       └─────────────────────────────────────┘         │
                        │              S105             │
       ┌─────────────────────────────────────┐         │
       │    CALCULATE TRANSMITTABLE POWER     │         │
       │ AMOUNT OF PERSONAL COMPUTER AND STORE│         │
       │    TRANSMITTABLE POWER AMOUNT        │         │
       └─────────────────────────────────────┘         │
                        │              S106             │
       ┌─────────────────────────────────────┐         │
       │  REQUEST PORTABLE GAME MACHINE TO    │         │
       │ PERFORM TEMPORARY POWER TRANSMISSION │         │
       └─────────────────────────────────────┘         │
                        │              S107             │
       ┌─────────────────────────────────────┐         │
       │ RECEIVE TRANSMITTED POWER AND REMAINING│       │
       │   AMOUNT FROM PORTABLE GAME MACHINE  │         │
       └─────────────────────────────────────┘         │
                        │              S108             │
       ┌─────────────────────────────────────┐         │
       │   STORE RECEIVED POWER OF PORTABLE   │         │
       │          GAME MACHINE               │         │
       └─────────────────────────────────────┘         │
                        │              S109             │
       ┌─────────────────────────────────────┐         │
       │ CALCULATE TRANSMITTABLE POWER AMOUNT │         │
       │  OF PORTABLE GAME MACHINE AND STORE  │         │
       │    TRANSMITTABLE POWER AMOUNT        │         │
       └─────────────────────────────────────┘         │
                        │                               │
                        ▼                               │
                       ①                                │
```

# FIG.5

4-2

①

S110
DOES TRANSMITTABLE POWER AMOUNT SATISFY CONDITION OF PERSONAL COMPUTER > PORTABLE GAME MACHINE?
YES →

NO ↓

S111
PERMIT POWER TRANSMISSION FROM PORTABLE GAME MACHINE

S117
PERMIT POWER TRANSMISSION FROM PERSONAL COMPUTER

S112
IS THERE DESIRED REMAINING AMOUNT IN PORTABLE GAME MACHINE?
YES ←

S118
IS THERE DESIRED REMAINING AMOUNT IN PERSONAL COMPUTER?
NO ←

NO ↓

S113
STOP POWER RECEPTION FROM PORTABLE GAME MACHINE

YES ↓

S119
STOP POWER RECEPTION FROM PERSONAL COMPUTER

S114
HAS CHARGING COMPLETED?
YES ←

END

NO ↓

S115
PERFORM TIMING BY VARIABLE TIMER

S116
STOP ALL OF POWER RECEPTIONS

②

# FIG.6

START PROCESS IN PERSONAL COMPUTER OR PORTABLE
GAME MACHINE (POWER TRANSMISSION SIDE)

S151

NO ← HAS AUTHENTICATION
REQUEST BEEN RECEIVED?

YES

S152

TRANSMIT TRANSMISSION POWER AND
REMAINING AMOUNT TO MOBILE PHONE

S153

NO ← HAS TRANSMISSION START BEEN RECEIVED?

YES

START POWER TRANSMISSION — S154

S155

HAS REMAINING AMOUNT BECOME → YES
DESIRED REMAINING AMOUNT?

NO

S156

HAS NOTIFICATION OF CHARGING COMPLETION BEEN → YES
RECEIVED FROM POWER TRANSMISSION DESTINATION?

NO

S157

HAS NOTIFICATION OF STOP OF POWER → YES
TRANSMISSION BEEN RECEIVED?

NO

S158

STOP POWER TRANSMISSION

END

# FIG.7

## FIG.8

8—1

START PROCESS IN MOBILE PHONE
(POWER RECEPTION SIDE)

S201

HAS REMAINING AMOUNT BECOME
PREDETERMINED REMAINING AMOUNT OR LESS?

NO

2

YES

S202

REQUEST PERSONAL COMPUTER TO PERFORM TEMPORARY
POWER TRANSMISSION

S203

RECEIVE TRANSMITTED POWER AND REMAINING AMOUNT
FROM PERSONAL COMPUTER

S204

STORE RECEIVED POWER OF PERSONAL COMPUTER

S205

CALCULATE TRANSMITTABLE POWER AMOUNT OF PERSONAL
COMPUTER AND STORE TRANSMITTABLE POWER AMOUNT

S206

REQUEST PORTABLE GAME MACHINE TO PERFORM
TEMPORARY POWER TRANSMISSION

S207

RECEIVE TRANSMITTED POWER AND REMAINING
AMOUNT FROM PORTABLE GAME MACHINE

S208

STORE RECEIVED POWER OF PORTABLE GAME MACHINE

S209

CALCULATE TRANSMITTABLE POWER AMOUNT OF PORTABLE
GAME MACHINE AND STORE TRANSMITTABLE POWER AMOUNT

S210

REQUEST TO PERFORM TEMPORARY POWER TRANSMISSION
FROM PERSONAL COMPUTER TO PORTABLE GAME MACHINE

S211

RECEIVE TRANSMITTABLE POWER AMOUNT AT TIME
OF TRANSMITTING POWER FROM PERSONAL COMPUTER TO
PORTABLE GAME MACHINE AND STORE TRANSMITTABLE POWER AMOUNT

S212

STORE RECEIVED POWER

S213

CALCULATE TRANSMITTABLE POWER FROM PORTABLE GAME MACHINE

1

**FIG.9**

①

S214
TRANSMITTABLE POWER AMOUNT FROM PERSONAL COMPUTER TO MOBILE PHONE > TRANSMITTABLE POWER AMOUNT FROM PORTABLE GAME MACHINE TO MOBILE PHONE?

YES →

NO ↓

S215
PERMIT POWER TRANSMISSION FROM MOBILE PHONE

S216
IS THERE DESIRED REMAINING AMOUNT IN MOBILE PHONE?
YES →

NO ↓

S217
STOP POWER TRANSMISSION FROM PORTABLE GAME MACHINE

S218
HAS CHARGING COMPLETED?
YES →

NO ↓

S219
PERFORM TIMING BY VARIABLE TIMER

S220
STOP ALL OF POWER RECEPTIONS

②

S221
PERMIT POWER TRANSMISSION FROM PERSONAL COMPUTER

S222
IS THERE DESIRED REMAINING AMOUNT IN PERSONAL COMPUTER?
NO →

YES ↓ S223
PERMIT POWER TRANSMISSION FROM PERSONAL COMPUTER TO MOBILE PHONE

S224
STOP POWER RECEPTION FROM PERSONAL COMPUTER

S225
STOP ALL OF POWER RECEPTIONS

END

8－2

28

**FIG.10**

# FIG.11

# FIG.12

**FIG.13**

700 PORTABLE GAME MACHINE

**FIG.14**

**FIG.15**

**EP 2 512 001 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4171758 B
- JP 2005151609 A
- JP 2005143181 A
- JP 2010183814 A
- JP 2011090036 A